Europäisches Patentamt

(19) European Patent Office

Office européen des brevets

(11) Publication number: **0 019 915**

**B1**

(12) **EUROPEAN PATENT SPECIFICATION**

(45) Date of publication of patent specification: **19.09.84**

(21) Application number: **80102980.2**

(22) Date of filing: **28.05.80**

(51) Int. Cl.³: **C 23 F 11/02, C 23 C 15/00, H 01 L 21/306, H 01 L 21/469**

(54) **Method for preventing the corrosion of Al and Al alloys.**

(30) Priority: **28.05.79 JP 65030/79**

(43) Date of publication of application:
**10.12.80 Bulletin 80/25**

(45) Publication of the grant of the patent:
**19.09.84 Bulletin 84/38**

(84) Designated Contracting States:
**DE GB NL**

(56) References cited:
**GB-A-1 499 857**
**GB-A-2 022 025**
**US-A-4 030 967**

**J. Vac Sci. Technol. 15(2) March/April 1978, 334-337**
**IBM Technical Disclosure Bulletin; Vol. 21 No. 6, November 1978, 2315**
**IEEE International electron devices meeting, technical digest, Washington Dec. 6-8 1976, US, New York, IEEE 1976, 205-6**

(73) Proprietor: **Hitachi, Ltd.**
**5-1, Marunouchi 1-chome**
**Chiyoda-ku Tokyo 100 (JP)**

(72) Inventor: **Iida, Shinya**
**2379, Renkouji**
**Tama-shi Tokyo (JP)**
Inventor: **Ueki, Kazuyoshi**
**1-1-61, Suehiro-cho**
**Ohme-shi Tokyo (JP)**
Inventor: **Mizutani, Tatsumi**
**4-815.2, Nishi-koigakubo**
**Kokubunji-shi Tokyo (JP)**
Inventor: **Komatsu, Hideo**
**2196-323, Hirai**
**Hinodemachi, Nishitama-gun Tokyo (JP)**
Inventor: **Hirobe, Kado**
**5-3-31-212, Midori-cho**
**Koganei-shi Tokyo (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

Courier Press, Leamington Spa, England.

## Description

Background of the Invention
(1) Field of the Invention:
The present invention relates to a method for preventing the corrosion of Al and Al alloys in contact with halogen element-containing substances, after the Al and Al alloys have been processed by the dry-etching method.

(2) Brief Description of the Prior Art:
Al, Al-Si alloys and Al-Cu-Si alloys are used as materials for electrodes and wires of semiconductor devices and surface acoustic wave devices. In this field recently methods are practiced by using the dry-etching technique for formation of patterns of electrodes or wires.

A gas containing an element of the halogen group is used as a reactive gas as an atmosphere for dry-etching of Al or Al alloy. As a chlorine-containing gas used as the reactive gas, there are used $HCl$, $BCl_3$, $CCl_4$, $PCl_3$, $SiCl_4$, $CCl_3F$, $C_2HCl_3$ and mixtures of two or more of these gases, and as a bromine-containing gas, there are used $CHBr_3$, $BBr_3$, $PBr_3$, $SiBr_4$ and mixtures of two or more of these gases. Furthermore, a mixture of a chlorine-containing gas and a bromine-containing gas and a mixture of a halogen-containing gas and another gas may be used.

A reactive gas such as mentioned above is introduced into an etching chamber, and a micro-wave or high frequency field is applied to the reactive gas to cause glow discharge and by utilizing generated ions or radicals, Al or an Al alloy, whose surface is provided with a mask of a photo-resist or electron resist is etched to effect fine processing.

When the processed sample after completion of the etching treatment is taken out into the open air the corrosion of Al or Al alloy is caused since the components of the reactive gas used for the etching operation adhere to the sample and react with the water contained in the air. This phenomenon takes place in case of pure aluminum, but the phenomenon is conspicuous in case of Al alloy, especially Cu-containing Al alloy. Ordinarily, the Cu content in Cu-containing Al alloys used for semiconductor devices is 0.5 to 4% by weight. The higher the Cu content, the more vigorous is the corrosion by adhesion of the halogen components. Ordinarily, as the amount of impurities contained in Al alloys is increased, the degree of corrosion is increased.

From the results of experiments made by the applicant, it was confirmed that in case of Al alloys where the above-mentioned corrosion is vigorous, corrosion takes place within several minutes when the sample is taken out into the open air. Accordingly, even if a corrosion-preventing treatment is carried out after the lapse of this period, no substantial effect can be attained. This, it was confirmed that in order to prevent the above-mentioned corrosion in Al and Al alloys, it is necessary to carry out a corrosion-preventing treatment in a bell jar used for etching immediately after completion of the etching operation.

The above-mentioned corrosion of Al or Al alloy by adhesion of halogen components is caused not only in the process for manufacture of semiconductor devices but also in other fields.

A method for dry-etching of Al and Al alloys is known from US—A—3,951,709 and 4,030,967. US—A—4,030,967 describes the plasma-etching of Al in which an initial etching step in the presence of a gaseous boron trihalide is included, in order to remove the surface layer of aluminium oxide which retards the etching process.

From the asrticle by P. M. Schaible et al., J. Vac. Sci. Technol. 15(2), 1978, p. 334 to 337 a plasma-etching method is known, by which Al may be etched in the presence of free halogens or of halogen compounds. Both references do not recognize the problem caused by the corrosion of the treated aluminium by the action of the reactive halogen ions.

In IBM Technical Disclosure Bulletin, vol. 21, no. 6, November 1978, there is mentioned that the reactive ion-etching of aluminium/copper metallisation on silicone semiconductor device wavers using a chlorine containing gas leaves a residue which can attack the remaining metals. This residue is removed by treating the aluminium after the plasma etching in a highly oxidizing plasma comprising 10% $CF_4$ and 90% $O_2$. This plasma removes the chlorine and the remaining $SiO_2$.

The problem of removing silicone dioxide-remainders is also mentioned in "Plasma-etching of aluminium", Holden et al., IEEE International Electron Devices Meeting, Technical Digest, Washington, December 6, to 8, 1976, US, New York, IEEE 1976. According to the method described there the plasma-etching of Al or Al-Si-alloys may be carried out in an atmosphere comprising $BCl_3$ or $Cl_2$-gas. After etching an Al-Si-alloy a thin $SiO_2$ residue remains which may be removed by means of an additional etching cycle in an atmosphere consisting of $CF_4$ and $O_2$. Obviously, the problem of remaining chlorine ions has not been recognized by the authors of the stated reference.

British patent 1 499 857 describes a process for etching an aluminium film carried on a semiconductor substrate in which a plasma etching step of the Al is carried out in an atmosphere comprising carbon tetrachloride and up to 15 volume % ammonia. The ammonia is added to the atmosphere in order to prevent surface damage of the finished work pieces when exposed to air. This known process, however, is disadvantageous, because the addition of $NH_3$ to the dry-etching atmosphere decreases the etching rate to an undesirable low level.

Up to now therefore there has not been developed a method which allows carrying out the plasma etching step with high effectiveness and with a high etching rate, together with the possibility of safely preventing the corrosion of Al and Al alloys which are still in contact with halogen after the dry-etching step.

## Summary of the Invention

It is therefore a primary object of the present invention to provide a method for preventing the corrosion of Al or Al alloys in contact with halogen components, which Al or Al alloys have been processed by the dry-etching method, by which the defects and disadvantages involved in the above-mentioned conventional techniques can be eliminated.

In accordance with the present invention, the above-mentioned aobject can be attained by a method for removing halogen containing components from Al and Al alloys which have been subjected to a dry-etching process in the presence of a halogen containing reactive gas, comprising the steps of

(1) sputtering the Al or Al alloy in an atmosphere comprising ammonia in a concentration of at least 10% by volume and at least one gas having no deleterious influence on Al and Al alloys, and

(2) washing the Al or Al alloy with running deionized water or dipping the Al or Al alloy in an alkaline aqueous solution for 0.5 to 2 minutes and washing it with running deionized water.

The ammonia content in the ammonia-containing atmosphere is preferably at least 50% by volume. As the ammonia concentration is high, the time of exposure of Al or an Al alloy to the plasma is shortened and the damage caused to the sample or contamination of the sample is reduced, and better results are obtained. If the ammonia content is lower than 10% by volume, the damage or contamination is increased and no good results are obtained.

As the gas to be incorporated in ammonia, there can be mentioned inert gases such as Ar, He and $N_2$ and Freon gases such as $CF_4$. These gases may be used singly or in the form ot a mixture of two or more of them. In short, any gas having no deleterious influence on Al and Al alloys, such as water and halogens, may be used. Especially good results are obtained when Freon gases such as $CF_4$ and other F-containing compounds are used.

In the present invention, Al or Al alloy is sputtered in an atmosphere containing ammonia. The sputtering time during which the sample is exposed to the plasma is preferably 0.5 to 5 minutes. If this time is shorter than 0.5 minute, the intended object of attaining a high corrosion-preventing effect cannot be sufficiently attained. If this time is longer than 5 minutes, the sample is excessively damaged or contaminated. A most preferred sputtering time is about 2 minutes.

It is preferred that the gas pressure of the ammonia-containing atmosphere by 1.33 to 400 Pa, especially 1.33 to 66.7 Pa, particularly especially 40 to 66.7 Pa. If the gas pressure is too low, the sample is excessively damaged or contaminated, and if the gas pressure is too high, generation of plasma becomes difficult and no good results are obtained. A higher gas pressure, however, is preferred as far as the plasma can be conveniently generated.

In order to generate plasma in the sputtering step, a micro-wave or high frequency field is applied to the above-mentioned atmosphere. In this case, the power density is adjusted to less than 0.3 $W/cm^2$. If the power density exceeds this level, a sample of Al or Al alloy is excessively damaged or contaminated and no good results are obtained. However, if the power density is too low, plasma is not generated and sputtering becomes impossible. Accordingly, the power density is adjusted to a level exceeding the critical value for generating plasma. A most preferred power density is in the range of from 0.2 to 0.25 $W/cm^2$.

As the sputtering apparatus, there is ordinarily used a diode type sputtering machine, but the applicable apparatus is not limited to this device. Any of apparatuses capable of generating plasma can be used. When the dry-etched sample is subjected to the corrosion-preventing treatment, it is preferred that sputtering be carried out in an ammonia-containing atmosphere in the sputtering apparatus used in the dry-etching step. The dry-etched Al or Al alloy should be subjected to the corrosion-preventing treatment just after completion of the etching operation. Accordingly, the sample is kept in the bell jar used for eching or is introduced into a different chamber maintained under reduced pressure, and sputtering is carried out in an ammonia-containing atmosphere.

The Al or Al alloy sample which has thus been sputtered in the ammonia-containing atmosphere is not corroded at all even if it is taken out into air. The reason is that the halogen element adhering at the surface of the sample, for example, Cl-, is stabilized and neutralized to $NH_4Cl$. However, if the sample is placed in a high-humidity atmosphere or dipped in water, stabilized $NH_4Cl$ is dissociated and Cl ions are formed again, causing the corrosion of Al or Al alloy.

In order to prevent corrosion by dissociation of stabilized $NH_4Cl$ or the like, the sample should either be washed with running deionized water, or should be dipped in an alkaline aqueous solution for 0.5 to 2 minutes and additionally washed with running deionized water. By this treatment $NH_4Cl$ or the like is removed and corrosion of Al or Al alloy will not be caused any more. If washing with running water is carried out at room temperature for a least 5 minutes, $NH_4Cl$ or the like is sufficiently removed. However, in case of a sample whose surfaces have many convexities and concavities the sufficient removal of adsorbed

$NH_4Cl$ or Cl is impossible. In this case, if this running water washing is carried out for more than 5 minutes after the sample has been dipped in an alkaline aqueous solution corrosion can be completely prevented. An alkaline aqueous solution containing Na or K has a deleterious influence on a semiconductor device including, for example, Si elements. Accordingly, an aqueous solution of ammonia, hydrazine hydrate or ethylene diamine is preferably used as the alkaline aqueous solution. If such a deleterious influence is not caused, other alkaline aqueous solutions may be used. It is preferred that the concentration of the aqueous solution of ammonia or hydrazine hydrate be high and at least 20% by volume. If the concentration is lower than this level, there is a fear of corrosion by water used for dilution. The dipping treatment in the alkaline aqueous solution is advantageous in that a high corrosion-preventing effect can be obtained even in case of Al alloy which has a relatively high Cu content and is readily corroded. When an aqueous solution of hydrazine hydrate is used as the alkaline aqueous solution, Al is not damaged at all and the dipping treatment may be conducted for more than 2 minutes, since hydrazine hydrate hardly reacts with Al, even if the sample is dipped in this solution for a sufficiently long time.

If the above-mentioned liquid washing is carried out after sputtering in an ammonia-containing atmosphere, the corrosion of Al or Al alloy can be prevented. If the step of sputtering in a $CF_4$-containing atmosphere is inserted before the step of sputtering in an ammonia-containing atmosphere, the corrosion-preventing effect is further enhanced, and this effect is especially conspicuous in case of Al or Al alloys which have been dry-etched in a gas containing $BCl_3$ or $CCl_4$.

The $CF_4$ content in the sputtering atmosphere is at least 10% by volume, preferably at least 50% by volume. As the gas to be incorporated into $CF_4$, there are preferably used inert gases such as Ar, He and $N_2$ and Freon gases other than $CF_4$. Any gas having no bad influence an Al or Al alloy samples, which have water and halogens, may be used. The reason for limitation of the gas composition in the sputtering atmosphere is the same as described above with respect to the ammonia-containing atmosphere.

The time of sputtering in the $CF_4$-containing atmosphere is 0.05 to 2 minutes, preferably 0.5 to 1 minute. If this sputtering time is longer than 2 minutes, the sample is excessively damaged or contaminated, and especially in case of a semiconductor device, Si or $SiO_2$ of the substrate below the Al lines is etched and no good results are obtained. If the sputtering time is shorter than 0.5 minute, no substantial effect is attained by insertion of this sputtering step.

The gas pressure of the $CF_4$-containing atmosphere is 1.33 to 133 Pa, preferably 1.33 to 66.7 Pa. The reason for the limitation of the gas pressure is the same as described above with respect to the ammonia-containing atmosphere.

The power density of a micro-wave or high frequency field applied to the $CF_4$-containing atmosphere is lower than 0.4 $W/cm^2$ but is above the critical value capable of plasma discharge. If the power density exceeds 0.4 $W/cm^2$, the sample is seriously damaged and no good results are obtained. A lower power density is preferred as far as discharge is possible. An apparatus as described above with respect to sputtering in the ammonia-containing atmosphere can similarly be used.

When the surface of the Al or Al alloy sample treated according to the corrosion-preventing method of the present invention is analyzed by XPS (X-ray photoelectron spectroscopy), no corroding components such as Cl are detected.

Good corrosion-preventing effects can be obtained when the corrosion-preventing method of the present invention is applied to Al and ordinary Al alloys. More specifically, good results are obtained when Al alloys used as wiring materials of semiconductor devices, such as an Al-Si alloy containing 1 to 4% by weight of Si, an Al-Cu alloy containing 0.5 to 4% by weight of Cu and an Al-Cu-Si alloy containing 0.5 to 4% by weight of Cu are treated according to the method of the present invention. Especially high corrosion-preventing effects can be obtained when Al and Al alloys which have been processed by the dry-etching method are treated according to the corrosion-preventing method of the present invention. This dry-etching method is one that is well-known in the field of manufacture of semiconductor devices, and the outline of this method is as described hereinbefore. All of Al and Al alloys processed according to this dry-etching method can be effectively treated according to the corrosion-preventing method of the present invention.

Detailed Description of the Presently Preferred Embodiments

Example 1

According to the sputtering method, a film of an Al-Cu-Si alloy containing 4% by weight of Cu and 2% by weight of Si was formed in a thickness of 2 $\mu$m on an Si substrate having a thermal oxide film having a thickness of 0.6 $\mu$m, and a mask of a photoresist (AZ 1350 manufactured by Shipley Co., USA) having a thickness of 1 $\mu$m was formed on the aluminum alloy film to form a predetermined pattern. The so formed sample was placed in an etching chamber of a diode type sputtering machine and $BCl_3$ gas was introduced at a flow rate of 50 ml/min to maintain a gas pressure of 24.0 Pa. A high frequency (13.56 MHz) field was applied to cause discharge and effect etching. The termination of etching was confirmed by an etching monitor using the Al spectrum at 396 nm as the monitor signal, and overetching was conducted for 5 minutes. After removal of $BCl_3$, $CF_4$ gas was introduced into the etching chamber at a flow rate of 10 cm³/min to keep a gas pressure of 20.0 Pa and sputtering was carried out with a high frequency power of 200W (power density = 0.2 W/cm²). After removal of $CF_4$, $NH_3$ gas was introduced at a flow rate of 30 cm³/min and sputtering was carried out with a highfrequency power of 200 W under a gas pressure of 40 Pa for 1.5 minutes. Then, dry $N_2$ was introduced into the bell jar to restore the atmospheric pressure, and the sample was taken out into air. In order to remove Cu residues, the sample was dipped in a solution of $HNO_3$ for 1 minute, and was subsequently washed with aqueous ammonia for 2 minutes and with water for 5 minutes and was dried. When the sample was observed, it was found that Al lines having a width of 2 to 3 $\mu$m were not corroded at all, and even if the Al wirings were subjected to subsequent processings, they were not changed at all.

### Example 2
A film of an Al-Si alloy containing 2% by weight of Si was formed in a thickness of 2 $\mu$m by vacuum deposition on an Si wafer having a diameter of 76 mm and including a thermal oxide film having a thickness of 0.6 $\mu$m. In the same manner as described in Example 1, a fine pattern mask of a photoresist was formed on the Al-Si alloy film and the sample was placed in an etching chamber of a diode type etching machine. A mixed gas of $CCl_4$ and He (mixing ratio = 1/10) was introduced into the etching chamber at a flow rate of 150 ml/min to keep a gas pressure of 24.0 Pa. A high frequency power of 13.56 MHz was applied at a power density of 0.5 W/cm² to cause discharge and effect etching. When the etching operation was conducted for 15 minutes, the termination of etching was confirmed, and the introduction of the mixed gas of $CCl_4$ and He was stopped and supply of the high frequency power was cut off. $NH_3$ gas was introduced at a flow rate of 50 ml/min to keep a gas pressure of 40.0 Pa and a high frequency power was applied at a power density of 0.2 W/cm². Then, the sample was taken out into air, and was then washed with running deionized water for 5 minutes. It was found that no corrosion took place in the wire pattern obtained according to this process, and it was confirmed that a sufficient corrosion-preventing effect could be attained by this process.

### Example 3
The same starting sample as described in Example 1 was placed in a bell jar of a diode type sputtering machine, and $BCl_3$ containing 10% by volume of $CF_4$ was introduced into the bell jar and the sample was sputtered and etched at a high frequency power density of 0.25 W/cm² for about 20 minutes to obtain a fine pattern composed on an Al-Cu-Si alloy. The introduction of the $BCl_3$ gas was stopped and a 1:1 mixed gas of $NH_3$ and $CF_4$ was introduced into the bell jar at a flow rate of 50 ml/min to keep a gas pressure of 13.3 Pa, and sputter cleaning was carried out at a high frequency power density of 0.15 W/cm² for 1.5 minutes. The sample was taken out into air, and was dipped in a solution containing nitric acid to remove the residual Cu. Then, the sample was washed with running water at room temperature for 5 minutes. When the surface of the sample was analyzed by XSP, components participating in corrosion, such as B and Cl, were not detected at all.

### Example 4
A film of an Al-Cu-Si alloy containing 1% by weight of Cu and 2% by weight of Si was formed in a thickness of 0.6 $\mu$m by sputtering vacuum deposition on a PSG film (phosphosilicate glass film), and a predetermined mask pattern was formed on the alloy film by using an electron beam resist. A plurality of the so formed samples was placed in an etching chamber and a mixed gas of $BCl_3$ and $CCl_4$ (each being fed at a flow rate of 100 ml/min) was introduced to keep a gas pressure of 26.7 Pa. A high frequency power was supplied at a power density of 0.3 W/cm² to cause discharge and effect etching of the Al alloy. The etching was completed within about 4.5 minutes and a wiring of the Al alloy was formed. Then, the supply of the mixed gas of $BCl_3$ and $CCl_4$ was cut off and the discharge was stopped. Thus, the bell jar was evacuated and the pressure was reduced. Then, $NH_3$ gas was introduced into the bell jar at a flow rate of 30 ml/min and also He gas was introduced at a flow rate of 30 ml/min to adjust the gas pressure to 66.7 Pa. A high frequency power was applied at a power density of 0.3 W/cm² for 1.5 minutes to effect plasma cleaning. The sample was taken out into air, dipped in an aqueous solution containing 30% by volume of ammonia for 1 minute and washed with running water for 5 minutes. The obtained sample was subjected to an accelerated degradation test where the sample was allowed to stand in an atmosphere maintained at a relative humidity of 80% and a temperature of 80°C for 10 hours. No corrosion was caused to occur in the aluminum alloy wiring.

Obviously many modifications and variations of the present invention are possible in the light of the above teachings. It is therefore to be understood that within the scope of the appended claims the invention may be practised otherwise than as specifically described.

## Claims

1. A method for removing halogen containing components from Al and Al alloys which have been subjected to a dry-etching process in the presence of a halogen containing reactive gas, comprising the steps of

(1) sputtering the Al or Al alloy in an atmosphere comprising ammonia in a concentration of at least 10% by volume and at least one gas having no deleterious influence on Al and Al alloys, and

(2) washing the Al or Al alloy with running deionized water or dipping the Al or Al alloy in an alkaline aqueous solution for 0.5 to 2 minutes and washing it with running deionized water.

2. The method of claim 1 wherein the additional step of sputtering Al or Al alloy in an atmosphere containing $CF_4$ is carried out prior to said step (1).

3. The method of either of claims 1 or 2, wherein the ammonia content in the atmosphere is at least 50% by volume.

4. The method of any of claims 1 to 3, wherein the alkaline aqueous solution used in step (2) is an aqueous solution of ammonia or hydrazine hydrate.

5. A method according to any of the claims 1 to 4, characterized in that the gas having no deleterious influence on Al and Al alloys is an inert gas or a Freon® gas.

**Revendications**

1. Procédé pour éliminer des composants contenant un halogène à partir du Al ou d'alliages de Al qui ont été soumis à un processus d'attaque chimique à sec en présence d'un gaz réactif contenant un halogène, comprenant les phases opératoires suivantes:

(1) à pulvériser le Al ou l'alliage de Al dans une atmosphère contenant de l'ammoniac en une teneur égale à au moins 10% en volume et, au moins un gaz n'ayant aucune influence nuisible sur le Al et sur les alliages de Al, et

(2) à laver le Al ou l'alliage de Al avec de l'eau désionisée en écoulement ou à immerger le Al ou l'alliage de Al dans une solution aqueuse alcaline pendant une durée comprise entre 0,5 et 2 minutes et à le laver avec de l'eau désionisée en écoulement.

2. Procédé de la revendication 1, selon lequel la phase opératoire additionnelle de pulvérisation du Al ou de l'aliage de Al dans une atmosphère contenant du $CF_4$ est affectuée avant ladite phase opératoire (1).

3. Procédé selon l'une ou l'autre des revendications 1 ou 2, selon lequel la teneur en ammoniac dans l'atmosphère est égale à au moins 50% en volume.

4. Procédé selon l'une quelconque des revendications 1 à 3, selon lequel la solution aqueuse alcaline utilisée dans la phase opératoire (2) est une solution aqueuse d'ammoniac ou d'hydrate d'hydrazine.

5. Procédé selon l'une quelconque des revendications 1 à 4, caractérisé en ce que le gaz n'ayant aucune influence nuisible sur le Al et sur les alliages de Al est un gaz inerte ou un gaz Fréon®.

**Patentansprüche**

1. Verfahren zum Entfernen von halogenhaltigen Bestandteilen aus Al und Al-Legierungen, die einem Trockenätzvorgang in Gegenwart eines halogenhaltigen reaktionsfähigen Gases unterzogen worden sind, umfassend die Schritte:

(1) Zerstäuben des Al bzw. der Al-Legierung in einer Atmosphäre, die Ammoniak in einer Konzentration von mindestens 10 Vol-% und mindestens ein Gas enthält, das auf Al und Al-Legierungen keinen schädlichen Einfluß hat, und

(2) Waschen des Al bzw. der Al-Legierung unter laufendem entionisiertem Wasser oder Eintauchen des Al bzw. der Al-Legierung in eine wässrige alkalische Lösung 0,5 bis 2 Minuten lang und Waschen unter laufendem entionisiertem Wasser.

2. Verfahren nach Anspruch 1, wobei vor dem besagten Schritt (1) der zusätzliche Schritt des Zerstäubens des Al bzw. der Al-Legierung in einer $CF_4$-haltigen Atmosphäre durchgeführt wird.

3. Verfahren nach Anspruch 1 oder 2, wobei der Ammoniakgehalt in der Atmosphäre mindestens 50 Vol-% beträgt.

4. Verfahren nach einem der Ansprüche 1 bis 3, wobei die in Schritt (2) verwendete wässrige alkalische Lösung eine wässrige Ammoniak- oder Hydrazinhydrat-Lösung ist.

5. Verfahren nach einem der Ansprüche 1 bis 4, dadurch gekennzeichnet, daß das Gas, das auf Al und Al-Legierungen keinen Schädlichen Einfluß hat, ein Inertgas oder ein Freon®-Gas ist.